# EUROPÄISCHE PATENTANMELDUNG

(11) **EP 1 713 299 A2**
(43) Veröffentlichungstag der Anmeldung: **18.10.2006**
(21) Anmeldenummer: 06112468.1
(22) Anmeldetag: 11.04.2006
(51) Int. Cl.: H04R 1/08

(54) **Mikrofonvorrichtung für ein Hörgerät**

(30) Priorität: 14.04.2005 DE 102005017357
(71) Anmelder: Siemens Audiologische Technik GmbH, 91058 Erlangen (DE)
(72) Erfinder: Niederdränk, Torsten, 259293 Singapore (SG); Sauer, Joseph, 96129 Strullendorf (DE); Trautner, Markus, 90489 Nürnberg (DE); Weistenhöfer, Christian, 91088 Bubenreuth (DE)
(74) Vertreter: Berg, Peter

(57) **Zusammenfassung**

Hörgeräte sollen weiter miniaturisiert und in ihrer Herstellung vereinfacht werden. Dazu ist vorgesehen, dass die Mikrofoneinrichtung für ein Hörgerät aus mindestens einem Siliziummikrofon (2) hergestellt wird, das auf einem MID-Kunststoffträger (Molded Interconnected Device) (1) aufgebracht wird. Dieser Kunststoffträger (1) besitzt dann die doppelte Funktionalität eines Mikrofongehäuseabschnitts und einer Leiterplatine.

## Beschreibung

Die vorliegende Erfindung betrifft eine Mikrofonvorrichtung für ein Hörgerät mit mindestens einem Siliziummikrofon. Insbesondere betrifft die vorliegende Erfindung ein Gehäuse oder einen Träger des mindestens einen Siliziummikrofons.

Mikrofone benötigen ein akustisch dichtes Gehäuse mit einem oder mehreren definierten Schalleinlässen und elektrischen Kontakten. Der Schallwandler arbeitet typischerweise nach dem Prinzip des Kondensatormikrofons und gibt dementsprechend ein schwaches, störanfälliges Signal ab. Daher ist in der Regel eine Signalnachverarbeitung und Verstärkung noch innerhalb des Gehäuses notwendig. Die Unterbringung von Schallwandler und Elektronik in einem Gehäuse begrenzt jedoch die weitere Miniaturisierung der Mikrofone.

Siliziummikrofone haben den Vorteil, dass Wandler und Signalverarbeitung aus je einem Chip bestehen und somit gemeinsam auf einer Platine untergebracht werden können. Dies erleichtert in erster Linie den Zusammenbau des Mikrofons. Siliziummikrofone zeichnen sich jedoch auch durch den geringen Bauraum aus. Ein derartiges Siliziummikrofon ist beispielsweise in der Druckschrift DE 38 07 251 A1 beschrieben.

Die Druckschrift EP 1 317 163 A2 offenbart ein Hörgerät mit einem Gerätegehäuse, in welchem eine Hörerbaueinheit und eine Mikrofonbaueinheit untergebracht sind. Elektronische Bauelemente der Mikrofonbaueinheit können auf einer Trägerplatte aufgelötet sein, welche als Formteil mit integrierter Leiterbildstruktur (Molded Interconnect Devices; MID) ausgebildet ist. Das Formteil kann dabei Teil des Gehäuses der Mikrofonbaueinheit sein. Zusätzlich wird vorgeschlagen, zumindest Teile des Gerätegehäuses als räumlich spritzgegossenen Schaltungsträger (Molded Interconnect Devices; MID) auszubilden.

Die Aufgabe der vorliegenden Erfindung besteht darin, Hörgerätemikrofone samt Gehäuse weiter zu miniaturisieren.

Erfindungsgemäß wird diese Aufgabe gelöst durch eine Mikrofonvorrichtung für ein Hörgerät mit mindestens einem Siliziummikrofon und einem MID-Kunststoffträger (Molded Interconnected Device), der zumindest Teil eines Gehäuses des mindestens einen Siliziummikrofons ist und der als Leiterplatte zur Kontaktierung des mindestens einen Siliziummikrofons dient.

Der Erfindung liegt die Erkenntnis zu Grunde, dass durch die Gestaltung der Platine des Siliziummikrofons als Gehäusebestandteil die Abmessungen des Mirkofons verringert werden können.

Durch die Verwendung eines MID-Trägers als Platine und Gehäusebauteil wird außerdem die Anzahl der mechanischen Bauteile reduziert. Die Monatage des Mikrofons wird ferner durch das Verkleben des MID-Trägers mit einer Gehäusehaube wesentlich vereinfacht. Die äußeren Abmessungen des Bauteils mit dem Siliziummikrofon und dem MID-Kunststoffträger können somit kleiner als bei bisherigen Siliziummikrofonen gestaltet werden.

Vorzugsweise ist an dem MID-Kunststoffträger ein Stutzen für den Schalleintritt angeformt. Dadurch ist ein Ankleben des Mikrofoneinlassstutzens in einem separaten Arbeitsgang nicht mehr notwendig. Dies ist insbesondere deswegen vorteilhaft, da an Verklebungen in Hörgeräten höchste Qualitätsanforderungen gestellt werden.

Günstigerweise ist auch eine Signalverarbeitungseinrichtung für das Siliziummikrofon auf dem MID-Kunststoffträger angeordnet und kontaktiert. Damit ist die Signalverarbeitung entsprechend nahe an dem Mikrofon angeordnet.

In einer speziellen Ausführungsform ist das Gehäuse des Siliziummikrofons oder ein Teil davon einteilig mit einer Hörgeräteschale gebildet, welche mit MID-Technik hergestellt ist. Somit besitzt die Hörgeräteschale die zusätzliche Funktionalität einer Platine.

Das Gehäuse des Siliziummikrofons kann teilweise aus Metall bestehen. Hierdurch wird die notwendige elektromagnetische Abschirmung realisiert.

Auch der MID-Kunststoffträger kann zumindest an einem Teil seiner Oberfläche metallisiert sein. Die geforderte elektrische und/oder magnetische Abschirmung lässt sich hierdurch optimieren.

In einer speziellen Ausgestaltung ist es möglich, dass das Siliziummikrofon in SMD-Technik direkt auf den MID-Kunststoffträger kontaktiert ist. Dadurch lässt sich ein hoher Grad an Automatisierung erzielen.

Zur Gewährleistung eines Richtmikrofons können mehrere Siliziummikrofone zu einem Mikrofon-Array zusammengefasst werden, welches an die Hörgeräteform angepasst ist. Durch die geringen Abmessungen von Siliziummikrofonen kann der Bauraum von Hörgeräten besser ausgenutzt werden, indem nämlich die Oberflächenkontur eines sich in erster Linie flächig erstreckenden Mikrofon-Arrays entsprechend der Hörgeräteform gestaltet wird.

Die vorliegende Erfindung wird nun anhand der beigefügten Zeichnungen näher erläutert, in denen zeigen:
- FIG 1: eine erfindungsgemäße Mirkofonvorrichtung mit Silizi-ummikrofon auf einem MID-Kunststoffträger;
- FIG 2: die Mikrofonvorrichtung von FIG 1 mit Gehäuseoberteil und
- FIG 3: die Mirkofonvorrichtung von FIG 2 von der Unterseite.

Das nachfolgend näher geschilderte Ausführungsbeispiel stellt eine bevorzugte Ausführungsform der vorliegenden Erfindung dar.

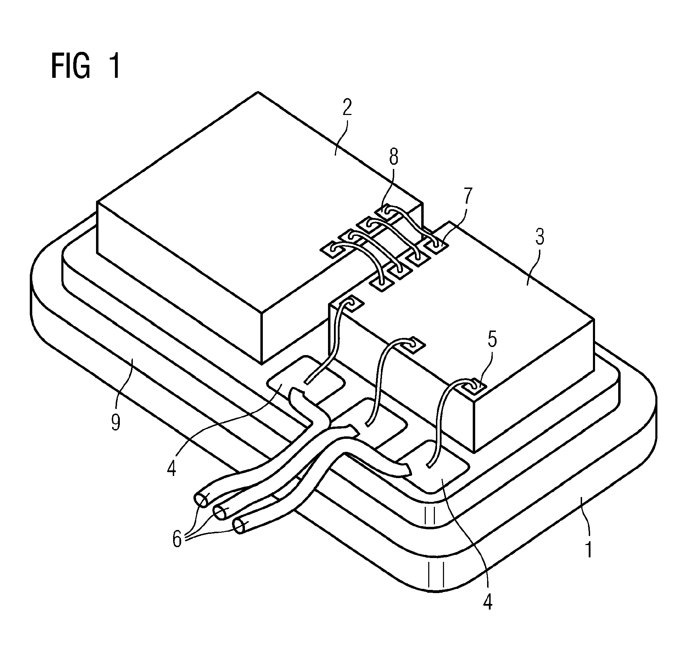

Entsprechend der Ausführungsform von FIG 1 ist die Platine 1 für das Siliziummikrofon 2 und den Vorverstärker 3 mit MID-Technologie (Molded Interconnected Device) hergestellt. Sowohl das Siliziummikrofon 2 als auch der Vorverstärker 3 sind als integrierte Schaltkreise aufgebaut, d. h. sowohl Schallwandler als auch Elektronik sind auf den MID-Kunststoffträger 1 montiert.

Im vorliegenden Beispiel sind auf der Oberfläche des MID-Kunststoffträgers 1 drei Kontaktstellen 4 auf den Kunststoffträger 1 aufgebracht. An diese Kontaktstellen 4 sind die Ausgangsanschlüsse 5 des Vorverstärkers 3 angebondet. Zur Weiterführung der Kontakte nach außen sind an die Kontaktstellen 4 Anschlussdrähte 6 angelötet. Darüber hinaus sind die Eingangskontakte 7 des Vorverstärkers 3 an die Ausgangskontakte 8 des Siliziummikrofons 2 gebondet.

Entsprechend einer alternativen Ausführungsform, die nicht zeichnerisch dargestellt ist, können die Kontakte des Siliziummikrofons und des Vorverstärkers an der Unterseite der jeweiligen integrierten Schaltung vorgesehen sein, so dass die beiden integrierten Schaltungen mit SMD-Technik auf den MID-Kunststoffträger aufgelötet werden können. Dies setzt voraus, dass die entsprechenden Anschlüsse und Kontaktierungen an korrespondierenden Stellen auf den MID-Kunststoffträger aufgebracht werden.

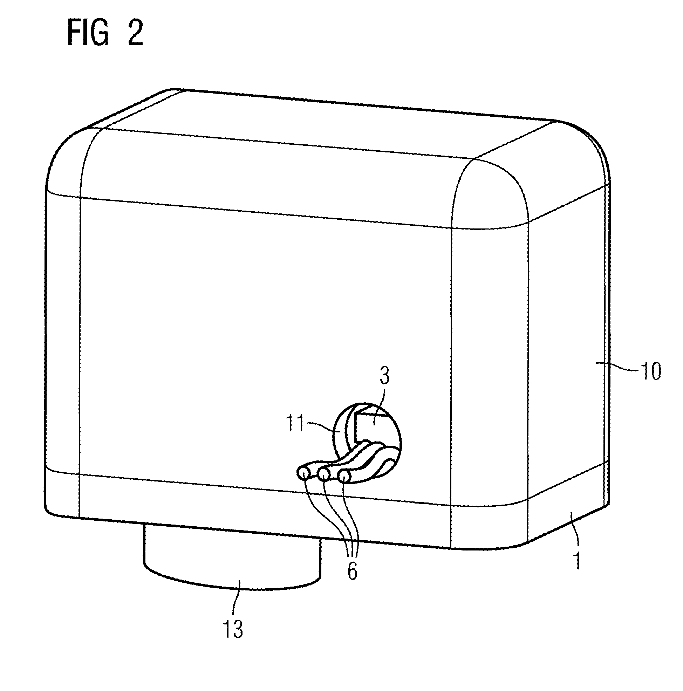

Der plattenförmige und als Platine dienende MID-Kunststoffträger 1 weist eine am Rand umlaufende Stufe 9 auf. Auf diese Stufe 9 lässt sich entsprechend FIG 2 ein Gehäuseoberteil 10 aufsetzen. Damit bildet der MID-Kunststoffträger 1 als Gehäuseunterteil mit dem Gehäuseoberteil 10 ein im Wesentlich geschlossenes Mikrofongehäuse.

Das Gehäuseoberteil 10 ist zu Abschirmzwecken vorzugsweise aus Metall hergestellt. In einer seiner Seitenwände befindet sich eine Aussparung 11, durch die die Anschlussdrähte 6 nach außen geführt sind.

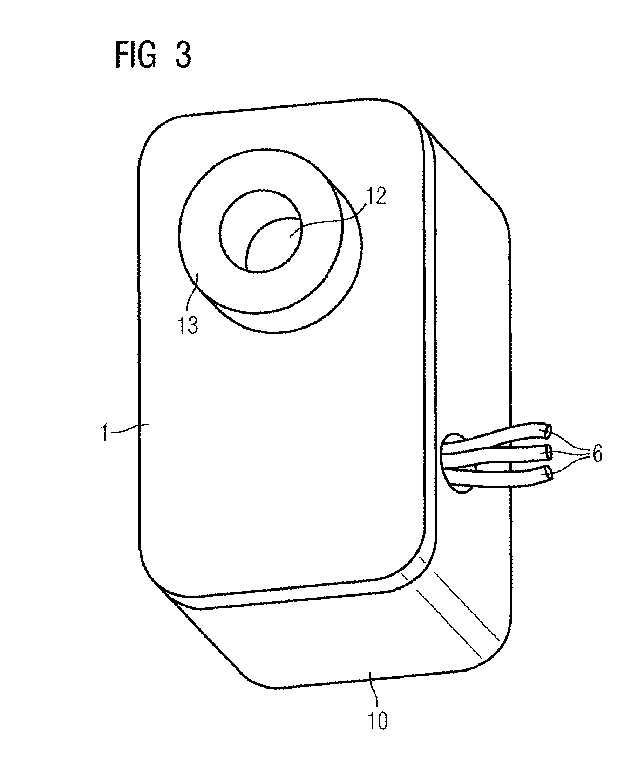

An der Unterseite des MID-Kunststoffträgers 1 unmittelbar unter dem Siliziummikrofon 2 befindet sich eine Schalleintrittsöffnung 12. Diese ist in der Unterseitenansicht von FIG 3 deutlich zu erkennen. Die Schalleintrittsöffnung 12 ist von einem rohrförmigen Stutzen 13 umgeben, mit dem der eintretende Schall besser zur Schalleintrittsöffnung 12 gelenkt wird. Zu diesem Zweck kann das Innere des Stutzens 13 kegelförmig ausgestaltet sein.

Durch die MID-Technologie lässt sich der Stutzen 13 einteilig mit dem MID-Kunststoffträger 1, d. h. der Anschlussplatine für das Siliziummikrofon 2 und den Vorverstärker 3 ausführen. Dies stellt einen deutlichen Vorteil gegenüber dem Stand der Technik dar. Wurde nämlich entsprechend dem Stand der Technik eine konventionelle Platine in ein Mikrofongehäuse mit integrierten Stutzen eingebaut, so ist ein entsprechend großer Bauraum für die Platine vorzusehen, wenn die Platine nicht gleichzeitig als Gehäusebestandteil verwendet wird.

Wird hingegen eine konventionelle Platine als Gehäusebestandteil genutzt, so muss zur verbesserten Schallübertragung ein Schallstutzen 13 an die konventionelle Platine angeklebt werden. Dies bedeutet die Handhabung mehrer Komponenten und den zusätzlichen Arbeitsschritt des Klebens.

Diese Nachteile werden durch den erfindungsgemäßen MID-Kunststoffträger 1 vermieden, und es werden die Vorteile beider oben geschilderten Bauformen miteinander kombiniert. Zum einen wird nämlich die Platine als Gehäuseunterteil verwendet, so dass die Abmessungen der gesamten Mikrofoneinheit verringert werden können, und zum anderen wird der Mikrofoneinlassstutzen 13 direkt an den MID-Kunststoffträger 1 angespritzt, so dass sich ein präzise auszuführender Klebeschritt einsparen lässt.

Zur Verbesserung der elektromagnetischen Verträglichkeit kann der MID-Kunststoffträger 1 metallisiert werden. Ebenso kann das Gehäuseoberteil 10 aus einem Kunststoff gespritzt und nachträglich metallisiert werden, oder besser ganz aus Metall bestehen.

Gemäß einer weiteren Ausführungsform werden mehrere Siliziummikrofone einschließlich eines Vorverstärker-ICs auf den MID-Kunststoffträger aufgebracht. Dabei besteht die Möglichkeit, dass der MID-Kunststoffträger, wie eingangs bereits erwähnt, exakt an die Hörgeräteform angepasst wird, so dass zusätzlich Bauraum eingespart werden kann.

Noch günstiger hinsichtlich des Bauraums ist, wenn die Hörgeräteschale im MID-Technologie hergestellt wird, so dass die Siliziummikrofone und weitere elektronische Bauteile unmittelbar an die Hörgerätegehäuseschale kontaktiert werden können. Dadurch lässt sich nicht nur der Bauraum einer eigenen Platine vermeiden, sondern es kann auch der logistische Aufwand für die Montage eines Hörgeräts reduziert werden.

## Patentansprüche

1. Mikrofonvorrichtung für ein Hörgerät mit
- mindestens einem Siliziummikrofon (2),
**gekennzeichnet durch**,
- einen MID-Kunststoffträger (1), der zumindest Teil eines Gehäuses des mindestens einen Siliziummikrofons (2) ist und der als Leiterplatte zur Kontaktierung des mindestens einen Siliziummikrofons (2) dient.

2. Mikrofonvorrichtung nach Anspruch 1, wobei an den MID-Kunststoffträger ein Stutzen (13) für den Schalleintritt angeformt ist.

3. Mikrofonvorrichtung nach Anspruch 1 oder 2, wobei eine Signalverarbeitungseinrichtung (3) für das Siliziummikrofon (2) auf dem MID-Kunststoffträger (1) angeordnet und kontaktiert ist.

4. Mikrofonvorrichtung nach einem der vorhergehenden Ansprüche, wobei das Gehäuse des Siliziummikrofons (2), oder ein Teil davon einteilig mit einer Hörgeräteschale gebildet ist, welche mit MID-Technik hergestellt ist.

5. Mikrofonvorrichtung nach einem der vorhergehenden Ansprüche, wobei das Gehäuse des Siliziummikrofons (2) teilweise aus Metall besteht.

6. Mikrofonvorrichtung nach einem der vorhergehenden Ansprüche, wobei der MID-Kunststoffträger (1) zumindest an einem Teil seiner Oberfläche metallisiert ist.

7. Mikrofonvorrichtung nach einem der vorhergehenden Ansprüche, wobei das Siliziummikrofon (2) in SMD-Technik direkt auf den MID-Kunststoffträger (1) kontaktiert ist.

8. Mikrofonvorrichtung nach einem der vorhergehenden Ansprüche, wobei mehrere Siliziummikrofone zu einem Mikrofon-Array zusammengefasst sind, welches an die Hörgeräteform angepasst ist.
